# EUROPÄISCHE PATENTSCHRIFT

(11) **EP 2 438 205 B1**
(45) Veröffentlichungstag und Bekanntmachung des Hinweises auf die Patenterteilung: **22.10.2014**
(21) Anmeldenummer: 10721467.8
(22) Anmeldetag: 13.05.2010
(51) Int. Cl.: C23C 16/22, C23C 16/24, C23C 16/26, C23C 16/44, C23C 16/52

(54) **BESCHICHTUNGSANLAGE UND BESCHICHTUNGSVERFAHREN**
DEPOSITION DEVICE AND METHOD
INSTALLATION DE REVÊTEMENT

(30) Priorität: 02.06.2009 DE 102009023472
(43) Veröffentlichungstag der Anmeldung: 11.04.2012
(73) Patentinhaber: Fraunhofer-Gesellschaft zur Förderung der angewandten Forschung e.V., 80686 München (DE)
(72) Erfinder: HARIG, Tino, 38685 Langelsheim (DE); HÖFER, Markus, 38162 Cremlingen-Gardessen (DE); LAUKART, Artur, 38112 Braunschweig (DE); SCHÄFER, Lothar, 38527 Meine (DE); ARMGARDT, Markus, 38108 Braunschweig (DE)
(74) Vertreter: Andrae | Westendorp Patentanwälte Partnerschaft
(86) Internationale Anmeldenummer: PCT/EP2010/056621
(87) Internationale Veröffentlichungsnummer: WO 2010/139541

(56) Entgegenhaltungen:
- EP-A1- 1 258 914
- JP-A- 2009 038 398
- US-A1- 2007 128 861
- US-A1- 2008 095 937
- FRIGERI P A ET AL: "Hot wire chemical vapor deposition: limits and opportunities of protecting the tungsten catalyzer from silicide with a cavity" THIN SOLID FILMS, ELSEVIER-SEQUOIA S.A. LAUSANNE, CH LNKD- DOI:10.1016/J.TSF.2009.01.023, Bd. 517, Nr. 12, 30. April 2009 (2009-04-30), Seiten 3427-3430, XP026052738 ISSN: 0040-6090 [gefunden am 2009-01-22] in der Anmeldung erwähnt
- MATSUMURA H ET AL: "Recent progress of Cat-CVD research in Japan-bridging between the first and second Cat-CVD conferences" THIN SOLID FILMS, ELSEVIER-SEQUOIA S.A. LAUSANNE, CH, Bd. 430, Nr. 1-2, 22. April 2003 (2003-04-22), Seiten 7-14, XP004427510 ISSN: 0040-6090
- HAUBNER R ET AL: "DIAMOND GROWTH BY HOT-FILAMENT CHEMICAL VAPOR DEPOSITION: STATE OF THE ART" DIAMOND AND RELATED MATERIALS, ELSEVIER SCIENCE PUBLISHERS, AMSTERDAM, NL LNKD- DOI:10.1016/0925-9635(93)90008-P, Bd. 2, 1. Januar 1993 (1993-01-01), Seiten 1277-1294, XP000867627 ISSN: 0925-9635

## Beschreibung

Die Erfindung betrifft eine Beschichtungsanlage, enthaltend zumindest einen evakuierbaren Rezipienten, welcher zur Aufnahme eines Substrats vorgesehen ist, zumindest eine Gaszufuhreinrichtung, mittels welcher zumindest ein gasförmiger Prekursor in den Rezipienten einleitbar ist und zumindest eine Aktivierungseinrichtung, welche zumindest ein beheizbares Aktivierungselement enthält, dessen Ende an einer Befestigungsstelle an einem Halteelement befestigt ist, wobei ein Abschirmelement vorhanden ist, mit welchem zumindest die Befestigungsstelle zumindest teilweise vor der Einwirkung des gasförmigen Prekursors schützbar ist, wobei das Abschirmelement im Wesentlichen zylinderförmig ausgebildet ist, und an der dem Halteelement abgewandten Seite des Abschirmelementes ein Verschlusselement angeordnet ist, welches zumindest eine Austrittsöffnung aufweist. Weiterhin betrifft die Erfindung ein entsprechendes Beschichtungsverfahren.

Beschichtungsanlagen der eingangs genannten Art sind gemäß dem Stand der Technik dazu vorgesehen, ein Substrat mittels einer heißdrahtaktivierten chemischen Gasphasenabscheidung zu beschichten. Die abgeschiedenen Schichten können beispielsweise Kohlenstoff, Silizium oder Germanium enthalten. Entsprechend können die gasförmigen Prekursoren beispielsweise Methan, Monosilan, Monogerman, Ammoniak oder Trimethylsilan enthalten.

Aus P.A. Frigeri et al.: "Hot Wire Chemical Vapour Deposition: Limits and Opportunities of protecting the tungsten catalyzer from silizide with a cavity", Thin Solid Films Vol. 517, Iss. 12 (2009) 3427 ist bekannt, dass insbesondere an den kälteren Einspannstellen des Aktivierungselementes eine unerwünschte Umsetzung des Materials des Aktivierungselementes mit dem Prekursor stattfindet. Beispielsweise kann die Verwendung einer Silan-Verbindung als Prekursor zur Bildung von Silizid-Phasen am Aktivierungselement führen. Diese Silizid-Phasen verändern den elektrischen Widerstand, die Oberflächenbeschaffenheit und die mechanische Belastbarkeit des Aktivierungselementes, so dass dieses oftmals nach nur kurzem Einsatz ausgetauscht werden muss.

Zur Lösung dieses Problems schlägt der genannte Stand der Technik vor, einen Bereich um die Einspannstellen des als Aktivierungselement verwendeten Drahtes mit einem zylindrischen Edelstahlelement von 4 mm Durchmesser und einer Länge von 90 mm vor der Einwirkung des Prekursors zu schützen. Auf diese Weise soll die Lebensdauer des Aktivierungselementes vergrößert werden. Zwar zeigt der Stand der Technik eine solche Verlängerung der Lebensdauer, diese ist jedoch bei lange andauernden Beschichtungsverfahren oder zur Durchführung mehrerer kürzerer Beschichtungsverfahren unmittelbar hintereinander weiterhin unzureichend.

Der Erfindung liegt somit die Aufgabe zugrunde, die Lebensdauer eines Aktivierungselementes in einer Beschichtungsanlage zur heißdrahtaktivierten chemischen Gasphasenabscheidung zu verlängern.

Die Aufgabe wird erfindungsgemäß durch eine Beschichtungsanlage gemäß Anspruch 1 sowie ein Beschichtungsverfahren gemäß Anspruch 11 gelöst.

Erfindungsgemäß wird vorgeschlagen, in an sich bekannter Weise ein zu beschichtendes Substrat in einen evakuierbaren Rezipienten einzubringen. Der Rezipient besteht dabei beispielsweise aus Aluminium, Edelstahl, Keramik und/oder Glas. Über zumindest eine Gaszufuhreinrichtung wird zumindest ein gasförmiger Prekursor mit vorgebbarem Partialdruck in den Rezipienten eingeleitet. Beispielsweise kann der Prekursor Methan, Silane, Germane, Ammoniak, Trimethylsilan, Sauerstoff und/oder Wasserstoff enthalten.

Zur Schichtabscheidung wird ein im Innenraum des Rezipienten angeordnetes Aktivierungselement beheizt. Insbesondere kann die Beheizung des Aktivierungselementes durch eine Elektronenstoßheizung oder eine elektrische Widerstandsheizung erfolgen. Das Aktivierungselement enthält im Wesentlichen ein Refraktärmetall wie beispielsweise Molybdän, Niob, Wolfram oder Tantal oder eine Legierung aus diesen Metallen. Daneben kann das Aktivierungselement weitere chemische Elemente enthalten, welche entweder unvermeidbare Verunreinigungen darstellen oder als Legierungsbestandteil die Eigenschaften des Aktivierungselementes an die gewünschten Eigenschaften anpassen. Das Aktivierungselement kann in Form zumindest eines Drahtes, eines Zylinders, eines Rohres oder eines Bleches ausgebildet sein. Fallweise sind weitere geometrische Ausgestaltungen denkbar.

Das Aktivierungselement ist Teil einer Aktivierungseinrichtung, welche darüber hinaus zumindest ein Halteelement und/oder zumindest eine Stromversorgungseinrichtung und/oder zumindest ein Kontaktelement und/oder zumindest ein Abschirmelement und/oder weitere Elemente enthalten kann.

An der Oberfläche des Aktivierungselementes werden die Moleküle des gasförmigen Prekursors gespalten und/oder angeregt. Die Anregung und/oder Spaltung kann einen Schritt enthalten, welcher unter Einfluss einer heterogenen Katalyse an der Oberfläche des Aktivierungselementes abläuft. Die auf diese Weise aktivierten Moleküle gelangen an die Oberfläche des Substrats und bilden dort die gewünschte Beschichtung. Zur Vergrößerung der Oberfläche des Aktivierungselementes kann dieses einen oder mehrere Drähte enthalten. Daneben kann das Aktivierungselement weitere geometrische Elemente wie Platten, Bleche oder Zylinder enthalten.

Die Enden des Aktivierungselementes werden mittels zumindest einer Befestigungsstelle an zumindest einem Halteelement befestigt. Die Befestigung kann beispielsweise durch Klemmen, Schweißen oder mittels Federspannung erfolgen. Aufgrund der vergrößerten Wärmeleitfähigkeit und/oder der vergrößerten Wärmeabstrahlung des Halteelements kann das Aktivierungselement in einem Abschnitt in der Nähe der Befestigungsstelle eine geringere Temperatur aufweisen, verglichen mit einem Abschnitt, welcher eine größere Entfernung zur Befestigungsstelle aufweist. In diesem Fall kann an der Befestigungsstelle bzw. in deren Nähe die Temperatur des Aktivierungselementes soweit absinken, dass das Material des Aktivierungselementes mit dem Prekursor eine chemische Umsetzung erfährt. Beispielsweise kann ein wolframhaltiges Aktivierungselement mit einem siliziumhaltigen Prekursor eine Wolframsilizid-Phase bilden.

Um die Befestigungsstelle und/oder einen Abschnitt des Aktivierungselementes in der Nähe der Befestigungsstelle zumindest teilweise vor der Einwirkung des gasförmigen Prekursors zu schützen, wird erfindungsgemäß ein Abschirmelement vorgeschlagen. Unter einem Abschnitt des Aktivierungselementes, welcher sich in der Nähe der Befestigungsstelle befindet, wird erfindungsgemäß eine Teilfäche bzw. ein Teilabschnitt des Aktivierungselementes verstanden, in welchem die Temperatur des Aktivierungselementes unter die Grenztemperatur sinkt, bei welcher die für die Beschichtung erforderliche Dissoziations- und/oder Anregungsreaktion nicht mehr stattfindet oder das Material des Aktivierungselementes mit dem Prekursor eine chemische Umsetzung erfährt. Dies kann beispielsweise eine Temperatur von weniger als 2000°C, weniger als 1800°C, weniger als 1500°C oder weniger als 1300°C sein. Die geometrische Ausdehnung dieser Teilfäche bzw. dieses Teilabschnitts kann von der zugeführten Heizleistung und der Wärmeabfuhr über das Halteelement abhängig sein. Die Wärmeabfuhr über das Halteelement kann von dessen Querschnitt und/oder dessen Oberfläche abhängig sein. Von einem zumindest teilweisen Schutz vor der Einwirkung des gasförmigen Prekursors wird erfindungsgemäß ausgegangen, wenn der Partialdruck des gasförmigen Prekursors innerhalb des Abschirmelements geringer ist als im Außenraum des Abschirmelements. Der Partialdruck kann beispielsweise durch Messung oder durch eine Simulationsrechnung bestimmt werden.

Das Abschirmelement weist eine im Wesentlichen zylinderförmige Geometrie auf, wobei der Querschnitt des Zylinders polygonal oder rund sein kann. Ein runder Querschnitt kann eine konstante oder eine abschnittsweise veränderliche Krümmung aufweisen. Die Längserstreckung des Zylinders kann kleiner, größer oder gleich seinem Durchmesser sein. Der Querschnitt des Zylinders kann konstant oder variabel sein. Insbesondere werden für die Zwecke der vorliegenden Erfindung auch die mathematischen Formen eines Prismas, eines Quaders, eines Kegels oder eines Würfels als zylinderförmig angesehen.

In einer Ausführungsform der Erfindung kann das zylinderförmig ausgebildete Abschirmelement so angeordnet sein, dass die Längsachse im Wesentlichen parallel zur Längsachse des Aktivierungselementes angeordnet ist. Die Grundfläche des Abschirmelements kann auf dem Halteelement im Wesentlichen gasdicht angeordnet sein.

An der dem Halteelement abgewandten Seite des Abschirmelements ist erfindungsgemäß ein Verschlusselement angeordnet, welches den Innenraum des Abschirmelements nach Art eines Deckels abschirmt. Dabei weist das Verschlusselement eine Austrittsöffnung auf, durch welche das Aktivierungselement von der Befestigungsstelle ausgehend das freie Volumen des Rezipienten erreicht.

In einer Weiterbildung der Erfindung wird die Längserstreckung des Abschirmelements soweit vergrößert, dass auch ein Teilabschnitt des Aktivierungselementes, welcher die zur Aktivierung der Gasphase erforderliche Mindesttemperatur aufweist oder überschreitet, im Innenraum des Abschirmelements angeordnet ist. Auf diese Weise kann eine geringe Menge des gasförmigen Prekursors, welcher in das Innenvolumen des Abschirmelements eindringt, aktiviert werden, so dass die solchermaßen umgesetzten Moleküle mit dem Aktivierungselement an der Befestigungsstelle bzw. in der Nähe der Befestigungsstelle keine Umsetzung mehr erfahren.

Das Abschirmelement kann zumindest eine Trennwand aufweisen, welche das Innenvolumen des Abschirmelements in ein erstes Teilvolumen und ein zweites Teilvolumen trennt. Auf diese Weise kann der Übertritt des gasförmigen Prekursors vom freien Volumen des Rezipienten an die Befestigungsstelle bzw. in die Nähe der Befestigungsstelle des Aktivierungselementes weiter reduziert werden.

In einigen Ausführungsformen der Erfindung kann das Abschirmelement entlang seiner Längsachse einen veränderlichen Querschnitt aufweisen. Auf diese Weise kann beispielsweise ein erstes Teilvolumen des Abschirmelements, welches einen Bauraum für eine mechanische Befestigung des Aktivierungselementes am Halteelement umschließen muss, großvolumiger ausgeführt werden als ein weiter von der Befestigungsstelle entferntes Teilvolumen, welches lediglich das Aktivierungselement aufnehmen muss. Auf diese Weise kann der Partialdruck des Prekursors an der Befestigungsstelle verringert werden.

Da nicht bei allen Ausführungsformen der Erfindung ausgeschlossen werden kann, dass die Innenfläche der Begrenzungswand des Abschirmelements mit schichtbildenden Substanzen aus dem gasförmigen Prekursor dauerhaft kontaminiert wird, kann in einer Ausführungsform der Erfindung vorgesehen sein, dass ein Teil des Abschirmelements trennbar mit dem Halteelement verbunden ist. Auf diese Weise kann der trennbare Teil des Abschirmelements in besonders einfacher Weise ersetzt werden, wenn der Innenraum des Abschirmelements stark verschmutzt ist und damit das Ende seiner Lebensdauer erreicht hat. Beispielsweise kann das Abschirmelement stets zusammen mit dem Aktivierungselement ausgetauscht werden.

Zur weiteren Verringerung des Partialdrucks des gasförmigen Prekursors, welche zu einer weiteren Verlängerung der Lebensdauer des Aktivierungselementes führen kann, kann das Innenvolumen des Abschirmelements in eine Gasabfuhröffnung münden, welche mit einer Vakuumpumpe verbindbar ist. Auf diese Weise kann der Prekursor schnell und zuverlässig aus dem Innenraum des Abschirmelements abgeführt werden.

Eine weitere Verbesserung der Abfuhr des Prekursors ergibt sich, wenn das Innenvolumen des Abschirmelements darüber hinaus eine Gaszufuhröffnung aufweist, durch welche ein Reaktivgas und/oder ein Inertgas einbringbar ist. Auf diese Weise kann sich ein Pumpgasstrom ausbilden, welcher das Saugvermögen für den gasförmigen Prekursor erhöht. Weiterhin kann ein Reaktivgas dazu vorgesehen sein, mit dem Prekursor zu reagieren, so dass der Prekursor anschließend nicht mehr zur Umsetzung mit dem Material des Aktivierungselementes zur Verfügung steht. Weiterhin kann das Reaktivgas eine Schutzschicht auf dem Aktivierungselement ausbilden. Es ist darauf hinzuweisen, dass das in den Innenraum des Abschirmelements eingeleitete Reaktivgas und/oder Inertgas bei Betrieb der Beschichtungsanlage das Innenvolumen des Abschirmelements überwiegend durch die Gasabfuhröffnung verlässt und nicht durch die Austrittsöffnungen in das freie Volumen des evakuierbaren Rezipienten gelangt.

Alternativ oder kumulativ zum beschriebenen Einsatz einer mechanischen Vakuumpumpe kann der Partialdruck des Prekursors durch ein im Innenraum des Abschirmelements angeordnetes Sorptionsmaterial verringert werden. Beispielsweise kann hierfür ein Zeolith und/oder ein Metallschaum und/oder ein Titanfilm verwendet werden. Zur Vergrößerung des Saugvermögens des Sorptionsmaterials kann die Oberfläche des Sorptionsmaterials durch Einbringen von Rippen oder Fugen vergrößert werden. Weiterhin kann sich eine Vergrößerung des Saugvermögens des Sorptionsmaterials dadurch ergeben, dass das Abschirmelement beheizt oder gekühlt wird. Ein Titanfilm kann durch Kathodenzerstäubung oder thermische Verdampfung im Betrieb der Beschichtungsanlage fortlaufend oder zyklisch erneuert werden.

In einigen Ausführungsformen der Erfindung kann vorgesehen sein, dass das Abschirmelement gegenüber dem Halteelement und/oder dem Aktivierungselement elektrisch isoliert angeordnet ist. In diesem Fall kann zwischen dem Aktivierungselement und dem Abschirmelement und/oder zwischen dem Halteelement und dem Abschirmelement durch Anlegen einer Gleich- oder Wechselspannung eine Plasmaentladung gezündet werden. Die Plasmaentladung kann dazu verwendet werden, Moleküle des gasförmigen Prekursors in andere Verbindungen umzusetzen, welche mit dem Material des Aktivierungselementes nicht mehr oder langsamer reagieren oder auf dem Aktivierungselement im Bereich der Befestigungsstelle eine Schutzschicht bilden.

Nachfolgend soll die Erfindung anhand von Ausführungsbeispielen und Figuren ohne Beschränkung des allgemeinen Erfindungsgedankens näher erläutert werden. Dabei zeigt
Figur 1 den prinzipiellen Aufbau einer erfindungsgemäßen Beschichtungsanlage.
Figur 2 illustriert eine mögliche Ausführungsform des erfindungsgemäß vorgeschlagenen Abschirmelements.
Figur 3 zeigt einen Querschnitt durch eine weitere Ausführungsform des Abschirmelements gemäß der vorliegenden Erfindung.

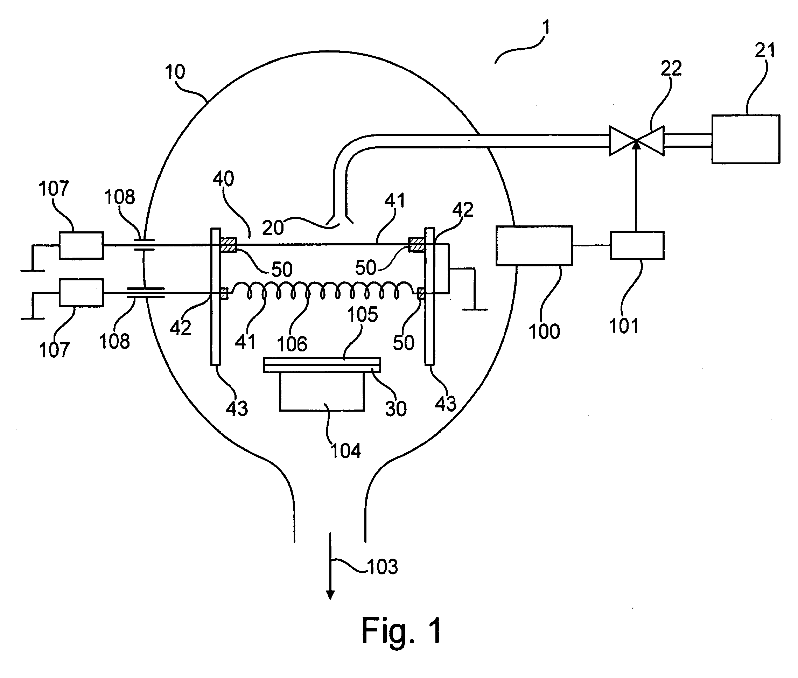

Figur 1 zeigt einen Querschnitt durch eine Beschichtungsanlage 1. Die Beschichtungsanlage 1 umfasst einen Rezipienten 10, welcher beispielsweise aus Edelstahl, Aluminium, Glas oder einer Kombination dieser Materialien hergestellt ist. Der Rezipient 10 ist gegenüber der Umgebung im Wesentlichen luftdicht abgeschlossen. Über einen Pumpenflansch 103 kann eine nicht dargestellte Vakuumpumpe angeschlossen werden. Beispielsweise kann der Rezipient 10 auf einen Druck von weniger als 10° mbar, weniger als 10⁻² mbar oder weniger als 10⁻⁶ mbar evakuiert werden.

Innerhalb des Rezipienten 10 befindet sich eine Haltevorrichtung 104, auf welcher ein Substrat 30 gehaltert werden kann. Das Substrat 30 kann beispielsweise aus Glas, Silizium, Kunststoff, Keramik, Metall oder einer Legierung bestehen. Beispielsweise kann das Substrat ein Halbleiterwafer, eine Scheibe oder ein Werkzeug sein. Es kann eine ebene oder gekrümmte Oberfläche aufweisen. Die genannten Materialien sind dabei nur beispielhaft genannt. Die Erfindung lehrt nicht die Verwendung eines bestimmten Substrates als Lösungsprinzip. Bei Betrieb der Beschichtungsanlage 1 wird auf dem Substrat 30 eine Beschichtung 105 abgeschieden.

Die Zusammensetzung der Beschichtung 105 wird durch die Wahl des gasförmigen Prekursors beeinflusst. In einer Ausführungsform der Erfindung kann der Prekursor Methan enthalten, so dass die Beschichtung 105 Diamant oder diamantartigen Kohlenstoff enthält. In einer anderen Ausführungsform der Erfindung kann der Prekursor Monosilan und/oder Monogerman enthalten, so dass die Beschichtung kristallines oder amorphes Silizium und/oder Germanium enthält.

Der gasförmige Prekursor wird über mindestens eine Gaszufuhreinrichtung 20 in das Innere des Rezipienten 10 eingebracht. Die Gaszufuhreinrichtung 20 bezieht den gasförmigen Prekursor aus einem Vorratsbehälter 21. Die Menge des aus dem Vorratsbehälter 21 entnommenen Prekursors wird über ein Regelventil 22 beeinflusst. Sofern die Beschichtung 105 aus mehreren unterschiedlichen Prekursoren zusammengesetzt ist, kann der Vorratsbehälter 21 eine vorbereitete Gasmischung enthalten oder aber es können mehrere Gaszufuhreinrichtungen vorgesehen sein, welche jeweils eine Komponente des zusammengesetzten Prekursors in den Rezipienten 10 einleiten.

Die über das Regelventil 22 der Gaszufuhreinrichtung 20 zugeführte Menge des Prekursors wird über eine Regeleinrichtung 101 kontrolliert. Der Regeleinrichtung 101 wird ein IstWert eines Partial- oder Absolutdrucks durch eine Messeinrichtung 100 zugeführt.

Zur Aktivierung des gasförmigen Prekursors steht zumindest eine Aktivierungseinrichtung 40 zur Verfügung. Die Aktivierungseinrichtung enthält zumindest ein beheizbares Aktivierungselement 41. Das Aktivierungselement 41 enthält eine oder mehrere katalytisch wirksame Flächen, beispielsweise in Form eines Bleches, eines Rohres oder eines Drahtes. Beispielsweise kann die Aktivierungseinrichtung 40 zwei Drähte 41 enthalten, welche jeweils eine katalytisch aktive Oberfläche aufweisen. Beispielsweise können die Drähte 41 Wolfram, Niob, Molybdän und/oder Tantal enthalten. Die Drähte 41 können gerade gespannt sein oder mittels mehrerer Windungen 106 ausgeführt sein, wodurch sich die aktive Oberfläche des Drahtes 41 weiter vergrößert.

Das Aktivierungselement 41 ist an zumindest einer Befestigungsstelle 42 an zumindest einem Halteelement 43 befestigt. Das zumindest eine Halteelement 43 fixiert das Aktivierungselement 41 an einer vorgebbaren Position und mit einer vorgebbaren mechanischen Spannung.

Die katalytische Aktivität der Oberfläche der Aktivierungselemente 41 wird bei einer gegenüber der Raumtemperatur erhöhten Temperatur erreicht. Zur Erwärmung der Aktivierungselemente 41 ist gemäß Figur 1 vorgesehen, zumindest ein Ende eines Aktivierungselementes 41 mittels einer vakuumdichten Durchführung 108 mit einer Stromquelle 107 zu verbinden. In diesem Fall erfolgt die Erwärmung des Aktivierungselementes 41 durch Widerstandsheizung.

Aufgrund der Wärmeleitung und/oder der Wärmestrahlung der Halteelemente 43, welche sich auf einer niedrigeren Temperatur befinden, nimmt die Temperatur des Aktivierungselementes 41 ausgehend von der geometrischen Mitte zum Rand hin ab, wenn die Heizleistung über die Länge des Aktivierungselementes im Wesentlichen konstant ist. Dabei ergibt sich in der Nähe der Befestigungsstelle 42 eine Temperatur, bei welcher das Material des Aktivierungselementes 41 mit dem gasförmigen Prekursor zu unerwünschten Phasen umgesetzt werden kann, beispielsweise Karbiden und/oder Siliziden.

Um den Zutritt des gasförmigen Prekursors in diesen kälteren Bereich des Aktivierungselementes 41 zu reduzieren, ist erfindungsgemäß an den Befestigungsstellen 42 ein Abschirmelement 50 vorgesehen. Das Abschirmelement 50 ist einseitig an den Halteelementen 43 befestigt.

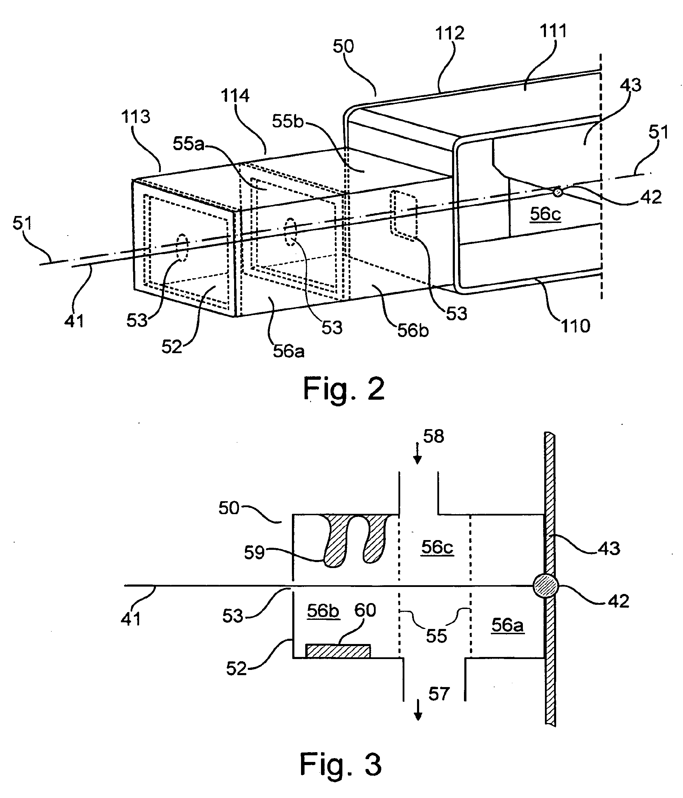

Figur 2 zeigt ein Ausführungsbeispiel eines Abschirmelementes 50. Im rechten Bildteil der Figur 2 ist ein Teil des Halteelementes 43 dargestellt. Am Halteelement 43 befindet sich eine Befestigungsstelle 42 eines Aktivierungselementes 41, welches im Wesentlichen aus einem Draht gebildet wird.

Die Befestigungsstelle 42 ist von einem kastenförmigen Gehäuse umgeben, welches aus einer unteren Begrenzungswand 110, einer oberen Begrenzungswand 111, einer Stirnwand 55b und zwei Seitenwänden 112 gebildet wird. Um den Innenraum 56c des Gehäuses sichtbar zu machen, ist in Figur 2 nur eine Seitenwand 112 dargestellt. Im Ausführungsbeispiel gemäß Figur 2 ist die obere Begrenzungswand 111, die Stirnwand 55b und die untere Begrenzungswand 110 einstückig aus einem einzigen Blechstreifen hergestellt. Dadurch hat das erste Gehäuse einen rechteckigen oder quadratischen Grundriss mit gerundeten Ecken. Selbstverständlich können auch andere Konstruktionsmöglichkeiten angewandt werden, beispielsweise kann das Abschirmelement 50 rotationssymmetrisch als Drehteil hergestellt sein.

Die Symmetrieachse 51 des kastenförmigen Gehäuses verläuft in etwa parallel zum Aktivierungselement 41. In einigen Ausführungsformen der Erfindung kann die Symmetrieachse 51 mit dem Aktivierungselement 41 zusammenfallen.

In der Stirnwand 55b befindet sich eine Austrittsöffnung 53, durch welche das Aktivierungselement 41 von der Befestigungsstelle 42 in das freie Volumen des Rezipienten 10 geleitet wird.

Um das Raumwinkelelement, aus welchem der Eintritt von Molekülen des Prekursors möglich ist, weiter zu reduzieren, weist das Abschirmelement 50 weitere kastenförmige Gehäuseteile 113 und 114 auf. Die Gehäuseteile 113 und 114 weisen einen rechteckigen Querschnitt auf. Der Fachmann wird jedoch erkennen, dass auch in diesem Fall ein anderer geometrischer Querschnitt gewählt werden kann. Insbesondere kann der Querschnitt polygonal oder rund sein. Die Gehäuseteile 113 und 114 sind über eine Trennwand 55a unterteilt, so dass sich zwei Teilvolumina 56a und 56b bilden. Auch die Trennwand 55a weist eine Austrittsöffnung 53 auf, um den ungehinderten Austritt des Aktivierungselementes 41 zu ermöglichen. Zum freien Volumen des Rezipienten 10 ist das Gehäuse 113 mittels eines Verschlusselements 52 abgeschlossen. Auch das Verschlusselement 52 ist mit einer Austrittsöffnung 53 versehen.

Im Betrieb der Beschichtungsanlage 1 kann das Aktivierungselement 41 der Aktivierungseinrichtung 40 so beheizt werden, dass die für die katalytische Zersetzung des gasförmigen Prekursors erforderliche Oberflächentemperatur zumindest im Teilvolumen 56a des Abschirmelements 50 erreicht wird. Im Teilvolumen 56b und 56c sinkt dann die Temperatur des Aktivierungselementes 41 bis auf die Temperatur des Halteelements 43 ab. Sofern Moleküle des Prekursors durch die Öffnungen 53 oder 54 in das Volumen 56a eintreten, stoßen sie dort mit großer Wahrscheinlichkeit gegen die Trennwand 55a oder eine Begrenzungsfläche des Gehäuseteils 113. In diesem Fall können die Moleküle das Volumen 56a entweder über eine der Öffnungen 53 oder 54 wieder verlassen oder sie werden vom entsprechend ausgestatteten Gehäusematerial des Gehäuseteils 113 absorbiert. Sofern ein Molekül mit dem Aktivierungselement 41 stößt, wird dieses aufgrund der hohen Temperatur des Aktivierungselementes 41 dissoziiert oder aktiviert, was meist zur Beschichtung der das Volumen 56a begrenzenden Wände führt. Eine Schädigung des Aktivierungselementes 41 im Volumen 56a ist damit aufgrund der hohen Temperatur des Aktivierungselementes 41 nicht verbunden.

Aufgrund der vorstehend beschriebenen Wirkung des ersten Gehäuseteils 113 ist der Partialdruck des Prekursors im Innenvolumen 56b des zweiten Gehäuseteils 114 gegenüber dem freien Volumen des Rezipienten 110 erniedrigt. Innerhalb des zweiten Volumens 56b findet nun eine weitere Reduktion des Partialdrucks statt, wie vorstehend beschrieben.

Da nun nur mehr eine geringe Anzahl von Molekülen das Teilvolumen 56c erreicht, ist innerhalb des Volumens 56c der Partialdruck des Prekursors minimal. Gleichzeitig befindet sich innerhalb des Teilvolumens 56b und/oder 56c derjenige Abschnitt des Aktivierungselementes 41, in welchem die Temperatur unterhalb des Grenzwertes sinkt, bei welchem eine Schädigung des Aktivierungselementes 41 wahrscheinlich wird. In diesem Bereich kann demnach eine unerwünschte Umsetzung des Aktivierungselementes mit dem Prekursor erfolgen. Aufgrund des abgesenkten Partialdruckes ist die unerwünschte Umsetzung des Materials des Aktivierungselementes 41 mit dem Prekursor im Innenvolumen 56c des Aktivierungselementes 50 jedoch wunschgemäß erniedrigt und die Lebensdauer des Aktivierungselementes 41 erhöht.

Figur 3 zeigt ein weiteres Ausführungsbeispiel des Abschirmelements 50. Im rechten Bildteil ist wiederum ein Ausschnitt eines Halteelements 43 dargestellt. Am Halteelement 43 befindet sich eine Befestigungsstelle 42 eines Aktivierungselementes 41. Die Befestigungsstelle 42 ist von einem Abschirmelement 50 umgeben, dessen Grundform beispielsweise ein Zylinder, ein Quader oder ein Prisma sein kann. Im Innenraum 56 des Abschirmelements 50 fällt die Temperatur des Aktivierungselementes 41 von einem für die Aktivierung des Prekursors geeigneten Wert auf die Temperatur des Halteelements 43 ab. Um den Partialdruck des gasförmigen Prekursors im Innenraum 56 des Abschirmelements 50 möglichst gering zu halten, ist der Innenraum 56 zum Rezipienten 10 hin durch ein Verschlusselement 52 abgeschlossen. Im Verschlusselement 52 befindet sich eine Austrittsöffnung 53, durch welche das Aktivierungselement austreten kann.

Der Innenraum 56 wird durch mindestens eine Trennwand 55 unterteilt. In Figur 3 sind zwei Trennwände 55 dargestellt, welche drei Teilvolumina 56a, 56b und 56c bewirken. Die Anzahl der Trennwände 55 kann in unterschiedlichen Ausführungsformen der Erfindung größer oder kleiner sein. Daher sind die Trennwände 55 in Figur 3 als gestrichelte Linie dargestellt.

Um den Partialdruck des Prekursors im Innenraum 56 zu verringern, sind verschiedene Maßnahmen ergriffen, um durch die Austrittsöffnung 53 eintretende Moleküle aus dem Innenraum 56 zu entfernen. Beispielsweise kann vorgesehen sein, durch eine Gasabfuhröffnung 57 mittels einer Vakuumpumpe die Moleküle aus dem Innenraum 56c zu entfernen. Die Art der verwendeten Vakuumpumpe wird der Fachmann an den gewünschten Totaldruck im Inneren des Volumens 56c anpassen. Beispielsweise kann eine Drehschieberpumpe, eine Scrollpumpe, eine Diffusionspumpe, eine Turbomolekularpumpe, eine Kryopumpe oder eine Kombination aus mehreren Pumpen verwendet werden.

Um die Pumpleistung zu erhöhen kann vorgesehen sein, durch eine Gaszufuhröffnung 58 ein Inertgas und/oder ein Reaktivgas in den Innenraum 56c einzuleiten. Ein Inertgas kann insbesondere dazu vorgesehen sein, einen Gasstrom im Volumen 56c aufrechtzuerhalten, welcher die unerwünschten Moleküle des Prekursors mitreißt und aus dem Volumen 56c entfernt. Ein Reaktivgas kann daneben weitere Wirkungen zur Verlängerung der Lebensdauer des Aktivierungselementes 41 entfalten. Beispielsweise kann das Reaktivgas eine Schutzschicht auf dem kälteren Abschnitt des Aktivierungselementes 41 ausbilden. Weiterhin kann das Reaktivgas mit den Molekülen des Prekursors reagieren und diese dabei zu einer Verbindung umzusetzen, welche mit dem Material des Aktivierungselementes 41 zumindest verlangsamt reagiert.

Kumulativ oder alternativ zur Gaszufuhröffnung 58 und/oder zur Gasabfuhröffnung 57 kann der Partialdruck im Volumen 56a auch dadurch gesenkt werden, dass für die Gehäusewandung des Abschirmelements 50 ein Material verwendet wird, welches den Prekursor bindet. Um eine hinreichend große Oberfläche bereitzustellen, kann hierzu vorgesehen sein, im Inneren des Volumens 56a Rippen 59 auszubilden. Diese können eine Teilfläche oder die gesamte Fläche der Innenwandung des Abschirmelements 50 bedecken.

Weiterhin kann vorgesehen sein, zumindest eine Teilfläche der Begrenzungswand des Abschirmelements 50 mit einer Schicht 60 eines Sorptionsmaterials bzw. eines Gettermaterials zu beschichten bzw. zu belegen. Auf diese Weise bildet die Wandung des Abschirmelements 50 eine Senke für den Prekursor, so dass der Partialdruck des Prekursors im Inneren des Volumens 56a sinkt. Auf diese Weise wird die Wechselwirkung des Prekursors mit den kälteren Abschnitten des Aktivierungselementes 41 reduziert, so dass die Lebensdauer des Aktivierungselementes 41 wunschgemäß verlängert wird.

Im Teilvolumen 56a sind keine weiteren Maßnahmen zur Senkung des Partialdruckes ergriffen. Eintretende Moleküle können aber mit der Innenwand des Abschirmelementes 50 reagiern oder sich dort niederschlagen.

Die Anordnung von Gaszufuhröffnungen 58 und/oder Gasabfuhröffnungen 57 und/oder Schichten 60 eines Sorptionsmaterials und/oder Rippen 59 in den Teilvolumina 56a, 56b und 56c ist lediglich beispielhaft dargestellt. In anderen Ausführungsformen der Erfindung können eine oder mehrere gleiche oder unterschiedliche Einrichtungen zur Senkung des Partialdruckes des Prekursors in einem einzigen Teilvolumen angeordnet sein oder auch entfallen.

Selbstverständlich können die in den Figuren 2 und 3 in Bezug auf das Abschirmelement 50 dargestellten Merkmale kombiniert werden, um auf diese Weise weitere Ausführungsformen des erfindungsgemäßen Abschirmelements und der erfindungsgemäßen Beschichtungsanlage zu erhalten. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche "erste" und "zweite" Merkmale definieren, so dient diese Bezeichnung der Unterscheidung zweier gleichartiger Merkmale, ohne eine Rangfolge festzulegen.

## Patentansprüche

1. Beschichtungsanlage (1), enthaltend zumindest einen evakuierbaren Rezipienten (10), welcher zur Aufnahme eines Substrates (30) vorgesehen ist, zumindest eine Gaszufuhreinrichtung (20, 21, 22), mittels welcher zumindest ein gasförmiger Prekursor in den Rezipienten (10) einleitbar ist und zumindest eine Aktivierungseinrichtung (40), welche zumindest ein beheizbares Aktivierungselement (41) enthält, dessen Ende an einer Befestigungsstelle (42) an einem Halteelement (43) befestigt ist, wobei ein Abschirmelement (50) vorhanden ist, mit welchem zumindest die Befestigungsstelle (42) zumindest teilweise vor der Einwirkung des gasförmigen Prekursors schützbar ist, wobei das Abschirmelement (50) eine Längserstreckung mit einer ersten Seite und einer zweiten Seite aufweist, wobei die erste Seite am Halteelement angeordnet ist und an der zweiten Seite des Abschirmelementes (50) ein Verschlusselement (52) angeordnet ist, welches zumindest eine Austrittsöffnung (53) aufweist, **dadurch gekennzeichnet, dass** im Inneren des Abschirmelementes (50) zumindest eine Trennwand (55) angeordnet ist, welche das Innenvolumen (56) des Abschirmelementes (50) in ein erstes Teilvolumen (56a) und ein zweites Teilvolumen (56b) trennt.

2. Beschichtungsanlage (1) nach Anspruch 1, **dadurch gekennzeichnet, dass** das Abschirmelement (50) entlang seiner Längsachse (51) einen veränderlichen Querschnitt aufweist.

3. Beschichtungsanlage (1) nach einem der Ansprüche 1 oder 2, **dadurch gekennzeichnet, dass** zumindest ein Teil des Abschirmelementes (50) trennbar mit dem Halteelement (43) verbunden ist.

4. Beschichtungsanlage (1) nach einem der Ansprüche 1 bis 3, **dadurch gekennzeichnet, dass** das Abschirmelement (50) eine Gasabfuhröffnung (57) aufweist, welche mit einer Vakuumpumpe verbindbar ist.

5. Beschichtungsanlage (1) nach Anspruch 4, **dadurch gekennzeichnet, dass** das Abschirmelement (50) eine Gaszufuhröffnung (58) aufweist, durch welche ein Reaktivgas und/oder ein Inertgas einbringbar ist.

6. Beschichtungsanlage (1) nach einem der Ansprüche 1 bis 5, **dadurch gekennzeichnet, dass** das Abschirmelement (50) vom Halteelement (43) und/oder vom Aktivierungselement (41) elektrisch isoliert ist.

7. Beschichtungsanlage (1) nach einem der Ansprüche 1 bis 6, **dadurch gekennzeichnet, dass** das Abschirmelement (50) auf seiner Innenseite Rippen (59) aufweist.

8. Beschichtungsanlage (1) nach einem der Ansprüche 1 bis 7, **dadurch gekennzeichnet, dass** das Abschirmelement (50) mit einem Sorptionsmaterial (60) versehen ist, welches insbesondere einen Zeolith und/oder einen Metallschaum und/oder einen Titanfilm enthält.

9. Beschichtungsanlage (1) nach einem der Ansprüche 1 bis 8, **dadurch gekennzeichnet, dass** das Abschirmelement (50) beheizbar ist.

10. Verfahren zur Herstellung einer Beschichtung (105) eines Substrates (30), bei welchem das Substrat in einen evakuierbaren Rezipienten (10) eingebracht wird, über zumindest eine Gaszufuhreinrichtung (20, 21, 22) zumindest ein gasförmiger Prekursor in den Rezipienten (10) eingeleitet und mittels zumindest einer Aktivierungseinrichtung (40) aktiviert wird, welche zumindest ein beheizbares Aktivierungselement (41) enthält, dessen Ende an einer Befestigungsstelle (42) an einem Halteelement (43) befestigt ist, wobei ein Abschirmelement (50) vorhanden ist, mit welchem zumindest die Befestigungsstelle (42) zumindest teilweise vor der Einwirkung des gasförmigen Prekursors geschützt wird, wobei das Abschirmelement (50) eine Längserstreckung mit einer ersten Seite und einer zweiten Seite aufweist, wobei die erste Seite am Halteelement angeordnet ist und an der zweiten Seite des Abschirmelementes (50) ein Verschlusselement (52) angeordnet ist, welches zumindest eine Austrittsöffnung (53) aufweist, **dadurch gekennzeichnet, dass** das Abschirmelement (50) zumindest eine Trennwand (55) aufweist, welche das Innenvolumen (56) des Abschirmelementes (50) in ein erstes Teilvolumen (56a) und ein zweites Teilvolumen (56b) trennt.

11. Verfahren nach Anspruch 10, bei welchem das Abschirmelement (50) beheizt wird.

12. Verfahren nach Anspruch 10 oder 11, bei welchem zumindest in einem Teilvolumen des Innenvolumens (56) des Abschirmelementes (50)ein Inertgas und/oder ein Reaktivgas eingebracht wird.

13. Verfahren nach Anspruch 12, bei welchem zumindest ein Teilvolumen des Innenvolumens (56) des Abschirmelementes (50) evakuiert wird.

14. Verfahren nach einem der Ansprüche 10 bis 13, bei welchem zumindest in einem Teilvolumen des Innenvolumens (56) des Abschirmelementes (50) eine Gasentladung gezündet wird.

15. Verfahren nach einem der Ansprüche 10 bis 14, bei welchem zumindest eine Teilfläche der Innenfläche des Abschirmelementes (50) mit einem Sorptionsmaterial versehen wird.

## Claims

1. Coating system (1), containing at least one evacuable recipient (10) which is provided for accommodating a substrate (30), at least one gas supply device (20, 21, 22), by means of which at least one gaseous precursor can be introduced into the recipient (10), and at least one activation device (40), which contains at least one heatable activation element (41), the end of which is attached to an attachment point (42) at a retaining element (43), wherein a shielding element (50) is available, by means of which at least the attachment point (42) can at least in part be protected from the influence of the gaseous precursor, wherein the shielding element (50) includes a longitudinal extension having a first side and a second side, wherein the first side is arranged on the retaining element and a closure element (52) is arranged on the second side of the shielding element (50), said closure element having at least one outlet opening (53), **characterized in that** at least one separating wall (55) is arranged in the interior of the shielding element (50), said separating wall separating the internal volume (56) of the shielding element (50) into a first subvolume (56a) and a second subvolume (56b).

2. Coating system (1) according to claim 1, **characterized in that** the shielding element (50) has a variable cross-section along its longitudinal axis (51).

3. Coating system (1) according to claim 1 or 2, **characterized in that** at least part of the shielding element (50) is separably connected to the retaining element (43).

4. Coating system (1) according to any of claims 1 to 3, **characterized in that** the shielding element (50) has a gas discharge opening (57) which can be connected to a vacuum pump.

5. Coating system (1) according to claim 4, **characterized in that** the shielding element (50) has a gas supply opening (58) through which a reactive gas and/or an inert gas can be introduced.

6. Coating system (1) according to any of claims 1 to 5, **characterized in that** the shielding element (50) is electrically insulated with respect to the retaining element (43) and/or the activation element (41).

7. Coating system (1) according to any of claims 1 to 6, **characterized in that** the shielding element (50) has ribs (59) on the inner side thereof.

8. Coating system according to any of claims 1 to 7, **characterized in that** the shielding element (50) is provided with a sorbent (60), which contains in particular a zeolite and/or a metal foam and/or a titanium film.

9. Coating system (1) according to any of claims 1 to 8, **characterized in that** the shielding element (50) can be heated.

10. Method for producing a coating (105) of a substrate (30), wherein the substrate is inserted in an evacuable recipient (10), at least one gaseous precursor is fed into the recipient (10) via at least one gas supply device (20, 21, 22) and is activated by at least one activation device (40) which contains at least one heatable activation element (41), the end of which is attached to an attachment point (42) at a retaining element (43), wherein a shielding element (50) is available, by means of which at least the attachment point (42) can at least in part be protected from the influence of the gaseous precursor, wherein the shielding element (50) includes a longitudinal extension having a first side and a second side, wherein the first side is arranged on the retaining element and a closure element (52) is arranged on the second side of the shielding element (50), said closure element having at least one outlet opening (53), **characterized in that** the shielding element (50) has at least one separating wall (55) which separates the internal volume (56) of the shielding element (50) into a first subvolume (56a) and a second subvolume (56b).

11. Method according to claim 10, wherein the shielding element (50) can be heated.

12. Method according to claim 10 or 11, wherein an inert gas and/or a reactive gas is introduced into at least one subvolume of the internal volume (56) of the shielding element (50).

13. Method according to claim 12, wherein at least one subvolume of the internal volume (56) of the shielding element (50) is evacuated.

14. Method according to any of claims 10 to 13, wherein a gas discharge is ignited at least in a subvolume of the internal volume (56) of the shielding element (50).

15. Method according to any of claims 10 to 14, wherein at least one subarea of the inner surface of the shielding element (50) is provided with a sorbent.

## Revendications

1. Installation de revêtement (1), contenant au moins un récipient susceptible d'être évacué (10) qui est prévu pour recevoir un substrat (30), au moins un moyen d'alimentation de gaz (20, 21, 22) au moyen duquel au moins un précurseur sous forme gazeuse peut être introduit dans le récipient (10), et au moins un moyen d'activation (14) qui contient au moins un élément d'activation (41) susceptible d'être chauffé et dont l'extrémité est fixée à un emplacement de fixation (42) sur un élément de maintien (43), dans laquelle est prévu un élément écran (50) avec lequel au moins l'emplacement de fixation (42) peut être protégé au moins partiellement de l'effet du précurseur sous forme gazeuse, dans laquelle l'élément écran (50) présente une extension longitudinale avec un premier côté et un second côté, dans laquelle le premier côté est agencé sur l'élément de maintien et sur le second côté de l'élément écran (50) est agencé un élément obturateur (52) qui comporte au moins une ouverture de sortie (53), **caractérisée en ce qu'**à l'intérieur de l'élément écran (50) est agencée au moins une paroi de séparation (55) qui sépare le volume intérieur (56) de l'élément écran (50) en un premier volume partiel (56a) et un second volume partiel (56b).

2. Installation de revêtement (1) selon la revendication 1, **caractérisée en ce que** l'élément écran (50) présente une section variable le long de son axe longitudinal (51).

3. Installation de revêtement (1) selon l'une des revendications 1 ou 2, **caractérisée en ce qu'**au moins une partie de l'élément écran (50) est reliée de façon séparable à l'élément de maintien (43).

4. Installation de revêtement (1) selon l'une des revendications 1 à 3, **caractérisée en ce que** l'élément écran (50) comporte une ouverture d'évacuation de gaz (57) qui peut être reliée à une pompe à vide.

5. Installation de revêtement (1) selon la revendication 4, **caractérisée en ce que** l'élément écran (50) comporte une ouverture d'admission de gaz (58) via laquelle un gaz réactif et/ou un gaz inerte est susceptible d'être introduit.

6. Installation de revêtement (1) selon l'une des revendications 1 à 5, **caractérisée en ce que** l'élément écran (50) est isolé électriquement de l'élément de maintien (43) et/ou de l'élément d'activation (41).

7. Installation de revêtement (1) selon l'une des revendications 1 à 6, **caractérisée en ce que** l'élément écran (50) comporte des nervures (59) sur son côté intérieur.

8. Installation de revêtement (1) selon l'une des revendications 1 à 7, **caractérisée en ce que** l'élément écran (50) est doté d'un matériau de sorption (60) qui contient en particulier une zéolite et/ou une mousse de métal et/ou un film de titane.

9. Installation de revêtement (1) selon l'une des revendications 1 à 8, **caractérisée en ce que** l'élément écran (50) est susceptible d'être chauffé.

10. Procédé pour la réalisation d'un revêtement (105) d'un substrat (30), dans lequel on introduit le substrat dans un récipient (50) susceptible d'être évacué, au moins un précurseur sous forme gazeuse est introduit dans le récipient (10) via au moins un moyen d'admission de gaz (20, 21, 22) et est activé au moyen d'au moins un moyen d'activation (14) qui contient au moins un élément d'activation (41) susceptible d'être chauffé et dont une extrémité est fixée à un emplacement de fixation (42) sur un élément de maintien (43), dans lequel il est prévu un élément écran (40) au moyen duquel au moins l'emplacement de fixation (42) est protégé au moins partiellement de l'effet du précurseur sous forme gazeuse, dans lequel l'élément écran (50) présente une extension longitudinale avec un premier côté et un second côté, le premier côté étant agencé sur l'élément de maintien, et sur le second côté de l'élément écran (50) est agencé un élément obturateur (52) qui comporte au moins une ouverture de sortie (53), **caractérisé en ce que** l'élément écran (50) comporte au moins une paroi de séparation qui sépare le volume intérieur (56) de l'élément écran (50) en un premier volume partiel (56a) et en un second volume partiel (56b).

11. Procédé selon la revendication 10, dans lequel l'élément écran (50) est chauffé.

12. Procédé selon la revendication 10 ou 11, dans lequel un gaz inerte et/ou un gaz réactif est introduit au moins dans un volume partiel du volume intérieur (56) de l'élément écran (50).

13. Procédé selon la revendication 12, dans lequel au moins un volume partiel du volume intérieur (56) de l'élément écran (50) est évacué.

14. Procédé selon l'une des revendications 10 à 13, dans lequel une décharge gazeuse est déclenchée dans au moins un volume partiel du volume intérieur (56) de l'élément écran (50).

15. Procédé selon l'une des revendications 10 à 14, dans lequel au moins une surface partielle de la surface intérieure de l'élément écran (50) est dotée d'un matériau de sorption.
